(19)

Europäisches
Patentamt

European
Patent Office

Office européen
des brevets

(11) **EP 4 210 112 A1**

(12) **EUROPEAN PATENT APPLICATION**

(43) Date of publication:
**12.07.2023 Bulletin 2023/28**

(21) Application number: **22150675.1**

(22) Date of filing: **10.01.2022**

(51) International Patent Classification (IPC):
*H01L 29/423* <sup>(2006.01)</sup>  *H01L 29/786* <sup>(2006.01)</sup>
*H01L 49/00* <sup>(2006.01)</sup>  *H01G 9/00* <sup>(2006.01)</sup>
*H01G 9/035* <sup>(2006.01)</sup>  *H01G 9/042* <sup>(2006.01)</sup>

(52) Cooperative Patent Classification (CPC):
**H10N 99/05; H01G 9/00; H01G 9/035; H01G 9/042;
H01L 29/42384; H01L 29/786**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Karlsruher Institut für Technologie
76131 Karlsruhe (DE)**

(72) Inventors:
• **XIE, Fangqing
76131 Karlsruhe (DE)**
• **SCHIMMEL, Thomas
76131 Karlsruhe (DE)**

(74) Representative: **Müller-Boré & Partner
Patentanwälte PartG mbB
Friedenheimer Brücke 21
80639 München (DE)**

(54) **FULLY METALLIC ATOMIC-SCALE TIN TRANSISTORS WITH ULTRALOW POWER DISSIPATION**

(57)    The present invention relates to an atomic-scale tin transistor device with ultralow power dissipation and a method for producing the same and its use.

EP 4 210 112 A1

**Description**

The present invention relates to an atomic-scale tin transistor device with ultralow power dissipation and a method for producing the same and its use.

Information and communication technology (ICT) has spread into all aspects of social society. Therefore, its energy consumption in devices and services has become of strategic importance and a sustainable issue for modern society. The energetics issue of ICT in the current and future raises a question of the ultimate energy efficiency of digital logic computation based on complementary metal-oxide-semiconductor (CMOS) technology. The advanced CMOS technology now faces a grand power consumption challenge due to a stagnation in the scaling of the supply voltage and the channel length. Yet, the lowering of the supply voltage and overall power consumption is precluded by the subthreshold swing of a metal-oxide-semiconductor field-effect transistor (MOSFET) which is found to be at 60 mV/decade and room temperature. These values are defined by the transport mechanism of CMOS devices based on thermionic emission over the barrier with fundamental thermionic limits (so-called Boltzmann tyranny). More precisely, the total switching energy ($E_{total}$) of a logic operation can be found as the sum of the dynamic, leakage, and interconnect components versus $V_{DD}$ as shown by the following Equation (1):

$$E_{total} = E_{dynamic} + E_{leakage} + E_{interconnect} \approx L_d C V_{DD}^2 \left( \propto + 10^{\frac{-V_{DD}}{S}} \right) + \propto C_{interconnect} V_{DD}^2 \qquad (1)$$

where $L_d$ is the logic depth, C is the switched capacitance, $V_{DD}$ is the supply voltage, $\alpha$ is the logic activity factor (typically ~0.01), and S is the subthreshold swing. Equation (1) indicates that the most effective way to control the power density is to scale down the supply voltage. The only way to decisively break the power dissipation bottleneck is to change the operation mechanism of a transistor in ways that facilitate the further reduction of operating voltage.

Considerable preliminary research has already been done on the fabrication of contacts between individual atoms, which is achieved in a mechanical way, whereby thin metallic bridges will be stretched out to such an extent that the contact area will be made up of a single or a few atoms in diameter. While such contacts frequently but not always turn out to be quantum point contacts having conductance values of integer multiples of the conductance quantum, their conductance values, which they adapt, can hardly be predetermined or adjusted beforehand on a predefined value. In fact, the conductance value of the metallic bridge is decreasing when its diameter is decreasing successively, mostly in several stages, until the bridge is breaking. The essential problem of the implementation of atomic or molecular electronics, i.e., the implementation of active components which made it possible by means of an independent third control electrode to control and adjust specifically the conductance value between source and drain electrode, is not yet solved therewith.

In the past there had been two approaches for solving this problem. In one approach, an atomic contact was repeatedly opened and closed while two macroscopic electrodes were moved towards one another and afterwards moved away from another and thus, requiring the movement of a macroscopic electrode. As for the second approach, D. Eigler et al., Nature 352 (1991) 600, succeeded in switching the position of a single atom in a tunneling microscope between two positions (on the tip of the tunnel and on the surface of the sample). In this case there is a component the only movable or moved part of which is a single atom. This atom flip-flop has not only the disadvantage that it operates in the shown configuration only at low temperatures (typically at 4 K up to 30 K) and in ultra-high vacuum, i.e., not under conditions where in technical applications electronic relays operate. Moreover, there is also no independent third electrode as a control electrode or gate available, instead the switching of the atom position of the movable atom is achieved by applying a potential to both electrodes the conductance value of which has to be switched. However, first and foremost, this arrangement does not allow to open and close an electrical circuit, but the resistance of the contact typically varies between 0% and 40% due to the switching of the position of the atom, whereby this percentage of variation cannot be predicted exactly.

A different approach has been described by the present inventors in WO 2006/026961 A2, disclosing metallic atomic-scale transistors operated with a novel fundamental switching paradigm. Specifically, a gate-controlled atomic switch is disclosed which comprises three electrodes: a source electrode, a drain electrode and a gate electrode, said source electrode and said drain electrode being connected to each other by means of an electrically conductive bridge made up of one or several silver (Ag) atoms which can be reversibly opened and closed; the opening and closing of the contact between said source electrode and said drain electrode being controllable by a potential applied to said gate electrode. That is, the only moveable elements of the atomic switch are the contacting Ag atoms and the electrical contact (gate) between the two electrodes which are called source and drain. This gate-controlled atomic switch operates at room temperature and without exclusion of oxygen. Besides this silver atomic-scale transistor that operates in an aqueous nitric electrolyte at voltages in the millivolt range (a few hundred millivolts), copper (Cu) and lead (Pb) atomic-scale transistors have been reported by F.Q. Xie et al. in Physical Review B 95, 195415 (2017), and Beilstein Journal of Nanotechnology 8, 530-538 (2017). However, the energy needed for switching in terms of the absolute value of the electrochemical potential to be applied to the gate electrode of the Cu atomic-scale transistors and Pb atomic-scale transistors are still in the range of a few hundred millivolts and several tens of millivolts, respectively. Another drawback of these transistors is the limitation as to the material of the source and drain electrodes. Only gold electrodes are reported for the atomic-scale Ag/Cu/Pb transistors.

In view of the above, it is an object of the present invention to overcome the above drawbacks and to provide a transistor device which should have a reduced power dissipation, specifically allowing a further reduction of the operating voltage (e.g., in the range of few millivolts) needed to switch the transistor from the off-state to the on-state and vice versa, and which should be available at lower costs and under safer conditions.

The above technical problem underlying the present invention has been solved by providing the embodiments characterized in the appended claims.

In particular, the present invention provides an atomic-scale tin transistor device which comprises a source electrode; a drain electrode; and a gate electrode, wherein the source, drain, and gate electrodes are spaced apart from one another and immersed in an electrolyte containing tin ions in an electrochemical cell, wherein the source electrode and drain electrode are connected to each other in the on-state by a bistable atomic-scale tin point-contact which can be reversibly opened and closed by dissolution/deposition potentials applied to the gate electrode, respectively, and wherein the atomic-scale tin point-contact consists in the on-state at its narrowest point of at least one tin atom up to a few hundreds of tin atoms formed by electrochemical deposition of tin.

Surprisingly, the operation potential of the atomic-scale tin transistor device according to the present invention can be 10 times lower than that of the above-mentioned atomic-scale Ag transistor disclosed in WO 2006/026961 A2. Notably, the power dissipation is proportional to the square of the operation potential. Advantageously, the atomic-scale tin transistor device according to the present invention has also a short channel length, high drain-source current (as high as several hundred microampere ($\mu$A) in magnitude), and low dynamic energy.

Furthermore, the on/off potentials are much lower than the constraint on the signal voltage swing (35.8 mV) of CMOS digital logic circuits by Landauer's limit and even smaller than the "action potentials" of neuron fire (-20 to -100 mV) in magnitude (cf. also O. Liu et al., Cell. 2018, 175, 57-70. e 17). The Landauer's limit is described in IBM Journal of research and development, "Irreversibility and heat generation in the computing process" 5, 183-191 (1961) as follows:

$$V_{DD} \geq 2(\ln 2)k_B T/e = 35.8 \text{ mV},$$

where $k_B$ represents the Boltzmann constant, T = 300 K, and e the electron charge.

The low on/off potentials in the atomic-scale tin transistor according to the present invention can reduce the energy consumption in the interconnects of integrated circuits at least by about 400 times in comparison with the digital logic circuits based on the CMOS technology. The conductance at on-states of the bistable configurations of the inventive transistor device has been demonstrated to vary between 1.2 $G_0$ to 197 $G_0$ ($G_0 = 2e^2 h^{-1}$, wherein e represents the electron charge and $h$ the Planck's constant). The drain-source current ($I_{DS}$) at the on-state (197 $G_0$) reaches about -375 $\mu$A when the drain-source dc voltage ($U_{DS}$) is set at -25 mV.

In the atomic-scale tin transistor according to the present invention, tin atoms as information carriers are considerably different from electrons or spins due to their natural weight and size. According to the Wentzel-Kramers-Brillouin approximation, the natural weight of tin atoms makes the channel length 3 nm or less, preferably even less than 1 nm.

Furthermore, the metallic property of the tin point-contact in the atomic-scale tin transistor of the present invention ensures high electrical current transport. The low on/off potentials of the transistor depend on the electrochemical characterization of metallic tin. Unlike the CMOS devices, the bit value is presented by the conductance of the atomic-scale tin point-contact in the transistor. Therefore, its information carriers are atoms instead of electrons. However, in this case, information is easily transferred back to the electrical domain, where nearly all information processing takes place today. Therefore, the atomic-scale tin transistor according to the present invention fulfills the requirements on an electronic device with ultralow power dissipation as a sustainable alternative to CMOS devices.

Besides, the atomic-scale tin transistor device is environmentally friendly and safe due to the non-toxic property of tin.

According to the present invention, the atomic-scale tin transistor device can be manufactured by a method comprising repeatedly applying potential cycles between the gate electrode and the source or drain electrode, respectively, for repeatedly depositing and dissolving tin atoms between the source electrode and drain electrode until the bistable atomic-scale tin point-contact has been formed, wherein the potential during the potential cycles is increased and subsequently lowered as long as due to the change of the potential at the gate electrode, the conductance value between the source electrode and the drain electrode can reproducibly be switched between two conductance values as a function of the potential of the gate electrode. That is, the fundamental idea of the manufacturing process according to the invention is the training of an electrochemically produced atomic point-contact by repeated cycling in the following manner.

Firstly, tin is galvanically deposited from the electrolyte in a small space (gap) between the source electrode and drain electrode until the contact between the two electrodes is closed and a preset upper conductance value X is exceeded. Specifically, during the deposition of tin, the source and drain electrodes become thicker and wider. Consequently, the gap between the two electrodes becomes narrower until, finally, a tin point-contact is formed in the gap. The deposition continues until the preset upper conductance value X is exceeded to stabilize the point-contact. Simultaneously, a tin film is deposited on the gate electrode by grounding the gate electrode. After the stabilizing procedure, the gate electrode is disconnected from the ground and electrically suspended in the electrolyte in order to prevent tin dissolution from the gate during the following training procedure. Then, immediately or with a defined time delay, a dissolution potential V2 is applied to the source and drain electrodes relative to the gate electrode (for instance, but not necessarily, by varying the potential of the quasi-reference electrode relative to a reference potential "ground" and not the potential of the source and drain electrodes) until the conductance value falls short of a lower conductance value Y, and then a deposition potential V1 will be applied again until in the contact the upper conductance value is reached and the cycle of applying the dissolution potential V2 starts again.

After some time of training, the junction geometries become increasingly stable and alternate between two stable conformations by variation of the electrochemical potential applied to the gate electrode. That is, this procedure (also called training of the tin point-contact) is repeated until the conductance value between the source electrode and the drain electrode can reproducibly and stably be switched between two conductance values as a function of the potential of the gate electrode. This behavior of the atomic-scale tin point-contact is referred to as "bistable", meaning that the system has two stable equilibrium states. By snapping into "magic" bistable conformations, junctions are mechanically and thermally stable at room temperature for long sequences of switching cycles, which offers interesting technological perspectives. The cyclic deposition/dissolution procedure thus trains the initially built atomic-scale tin transistor with the feedback mechanism, which is similar to the one previously described for the atomic-scale Ag and Pb transistors. Thus, the disclosure of WO 2006/026961 A2 relating to the training procedure is incorporated herein by reference.

In a preferred embodiment, the bistable atomic-scale tin point-contact in the on-state at its narrowest point consists of only one tin atom or of a few tin atoms, and by means of the tin transistor device an electrical circuit can be opened or closed through the change of the position of a single tin atom or a few tin atoms in the bistable atomic-scale tin point-contact. According to the present invention, the "on-state" thus refers to a state where the source electrode and the drain electrode are electrically connected to each other by the bistable atomic-scale tin point-contact, whereas the "off-state" refers to a state where the bistable atomic-scale tin point-contact between the source electrode and the drain electrode is opened, i.e., there is a gap between the source and drain electrodes.

Preferably, the cycling process is carried out between two or more specified gate electrode potentials, wherein the potential is varied in a rectangular, triangle, trapezoid, or sinusoidal waveform.

According to a preferred embodiment, the source and drain electrodes contain at least one metal selected from the group consisting of copper (Cu), ruthenium (Ru), rhodium (Rh), palladium (Pd), osmium (Os), iridium (Ir), platinum (Pt), gold (Au), and silver (Ag). These metals are also referred to as noble metals within the present invention. That is, the source and drain electrodes of the atomic-scale tin transistor device can be made of any noble metal, preferably selected from gold, silver, platinum, and copper. In contrast, for the atomic-scale Ag and Cu transistors, only gold and platinum can be used as working materials for the source and drain electrodes. Accordingly, according to the present invention, cheaper metals as working materials for the source and drain electrodes can be used.

In this context, it should be noted that the source and drain electrodes may be insulated with a polymer, for instance, except for a small window crossing both electrodes for the electrochemical deposition of tin.

The source and drain electrodes can be fabricated using lithographic methods. Specifically, the source and drain electrodes may be deposited by known methods on an insulating substrate. The substrate is not particularly limited as long as it is electrically insulating and can receive the electrodes. Examples of suitable materials for the substrate include silicon wafers and glass substrates without being limited thereto.

Preferably, the gate electrode consists of a tin wire or a metal film covered with a layer of tin. Specifically, the gate electrode may consist of a tin wire having a diameter of 0.5 mm, for instance, such as Puratronic® (99.9985%), or of a noble metal film covered with a layer of tin.

According to a preferred embodiment of the present invention, the electrolyte is an aqueous electrolyte comprising tin salts and acids such as $SnSO_4 + H_2SO_4$, $SnCl_2 + HCl$, $Sn(NO_3)_2 + HNO_3$, and $SnSO_4 + HBO_3$. According to the present invention, the electrolyte may be liquid or may be incorporated into a polymer or a porous, micro-porous or nano-porous system. Also, it is preferable that the electrolyte is an ionic liquid.

According to the present invention, the source, drain, and gate electrodes are immersed in the electrolyte containing tin ions in an electrochemical cell. The electrochemical cell can be made of any materials such as glass, ceramic, and polymers, and the dimensions can vary from millimeters to hundred nanometers.

According to the present invention, because the tin atoms are information carriers instead of electrons, the conductive channel length of the atomic-scale tin transistor device is preferably 3 nm or less, more preferably 1 nm or less. Preferably, the only movable parts of the atomic-scale tin transistor device are the tin atoms, which connect the source and drain electrodes. It is also preferable that the potential applied during the switching process will be given automatically by a control circuit or a signal source.

In addition to the low channel length, the atomic-scale tin transistor according to the present invention can be operated at ultralow operation voltage. Preferably, the gate potential is less than 35 mV in magnitude, more preferably 20 mV or less, most preferably 15 mV or less. As mentioned above, the electrochemical potential applied to the gate electrode can be 2.5 mV or less in absolute, which is much lower than the minimal level on the supply voltage of a CMOS digital logic circuit set by Landauer's limit (35.8 mV).

Further, the on-state conductance can vary between 1.2 Go to 197 Go. Also, it is preferred that the tunneling current at the off-state is less than 10 nA, more preferably a few nA, specifically less than 5 nA.

According to the present invention, drain-source current at on-state is preferably a few hundreds of $\mu$A, specifically 250 $\mu$A or more in magnitude, preferably 300 $\mu$A or more in magnitude, and most preferably 350 $\mu$A or more in magnitude.

The minimal switching-on energy of the transistor device according to the present invention is preferably 0.34 eV (13.1 $k_B$T at 300 K). The minimal switching-on energy is about 18.9 times larger than the ultimate limit on the minimum energy per switching at $k_B$Tln2 (Landauer's limit, approximately $3\times 10^{-21}$ J at room temperature). The maximal switching-on energy is estimated to be 3.99 eV (154.2 $k_B$T at 300 K).

As mentioned above, the conductance of the tin point-contact as a physical state variable can reside in two distinguishable on/off states. It can be controlled between the on/off states (write) by the gate potential, read by an electrical current through the tin point-contact, transmitted from one physical location to another via the electrical current, and initialized in a defined state (erase) just by setting the gate potential. The conductance of the tin point-contact as a state variable may compete with the thermal noise bath at room temperature.

The atomic-scale tin transistor device according to the present invention may be used in various forms, such as an atomic transistor or atomic relay, specifically for switching an electrical circuit by the atomic-scale tin transistor. It may be used for logic switches and/or carrying out logic operations. The transistor or relay may be used in the range of ultra-high frequencies from the megahertz range over the gigahertz range to the terahertz range. In addition, the atomic-scale tin transistor device according to the present invention may be used as building blocks of atom-based electronics.

In addition, the atomic-scale tin transistor can operate at room temperature or at temperatures between -30 °C and +50 °C, which meets the usual standards of the specification of the operation temperature of electronic components.

In the following, embodiments of the present invention are described in detail with reference to the accompanying Figures which show:

Fig. 1: A schematic diagram of an atomic-scale tin transistor according to the present invention.

Fig. 2: A quantum conductance switching controlled via the feedback mechanism. The top (a) shows the ramping wave between 8 and -30 mV which expresses the potential change on the gate, the middle (b) shows a digital graph which presents the conductance variation (0 - 14 Go) following the gate potential, and the bottom (c) is a rectangular curve which shows the corresponding current from 0 to -14 $\mu$A measured with $U_{DS}$ set to -12.9 mV.

Fig. 3: A function-generator-controlled quantum conductance switching between 0 and 7 $G_0$. The upper (a) shows the rectangular wave between 5 and - 15 mV which illustrates the potential applied to the gate by the virtual function generator, and the middle (b) digital signal exhibits quantum conductance switching between 0 and 7 $G_0$ succeeding the gate potential with a delay at 0.1 s. At the same time, the lower (c) rectangular wave demonstrates the corresponsive current variation in a digital form between 0 and -7 $\mu$A when $U_{DS}$ is set at -12.9 mV.

Fig. 4: Potential differences between the gate, source, and drain determined through $U_{DS}$ and the gate potential $U_G$ of an embodiment of the present invention.

Fig. 5: Demonstration of bistable conductive switching between 0 and different non-integer quantum conductance levels of an embodiment of the present invention.

Fig. 6: Demonstration of bistable conductive switching between 0 and different integer quantum conductance levels (from 2 $G_0$ to 6 $G_0$) of an embodiment of the present invention.

Fig. 7: Demonstration of bistable conductive switching between 0 and different integer quantum conductance levels (from 8 $G_0$ to 12 $G_0$) of an embodiment of the present invention.

Fig. 8: Demonstration of high quantum conductance (80 $G_0$) and current switching controlled via the feedback

**EP 4 210 112 A1**

mechanism in an atomic-scale tin transistor of an embodiment of the present invention.

Fig. 9: Cyclic voltammogram of tin performed in the electrolyte of SnSO₄ (10 mM) + H₂SO₄ (40 mM) in bi-distilled water.

Fig. 10: Influence of the switching-on gate potential ($U_G$) on the operation behaviors of an atomic-scale tin transistor of the present invention.

Fig. 11: Influence of the switching-off gate potential ($U_G$) on the operation behaviors of a nanoscale tin transistor.

Fig. 12: Influence of the dc voltage applied across the drain and source electrodes ($U_{DS}$) on the operation behaviors of an atomic-scale tin transistor of the present invention.

*Explanation of the procedure and the components according to the present invention*

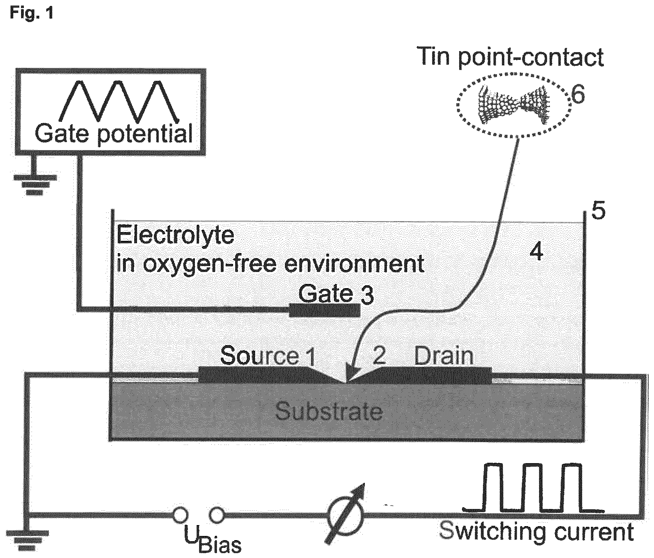

As illustrated in Fig. 1, the atomic-scale tin transistor is a modified electrolytic cell. In the electrolytic cell, electrical potential energy is converted to chemical potential energy. The electrolytic cell uses an electric current to force a particular chemical reaction to occur, which would otherwise not take place. A standard electrolytic cell consists of two electrodes and an electrolyte. One of two electrodes is the anode, where oxidation takes place. The cathode is the electrode where reduction takes place. In the atomic-scale tin transistor according to the present invention, the gate electrode (3) is taken as one electrode and the combination of source (1) and drain (2) as another. The source electrode is grounded. A dc voltage of a bias voltage ($U_{DS}$ or $U_{Bias}$) is applied to the drain electrode. When the gate potential ($U_G$) is larger than $U_{DS}$ ($U_G > U_{DS}$), the gate electrode is the anode, and the combination of source and drain is the cathode. Some tin atoms on the surface of the gate are oxidized and dissolved as ions into the electrolyte (4) according to Equation (2):

$$Sn \text{ (solid)} \rightarrow Sn^{2+} \text{ (aq.)} + 2e^-  \qquad (2)$$

At the same time, an equal number of ions are reduced on the surface of the combination of the source and drain electrodes according to Equation (3):

$$Sn^{2+} \text{ (aq.)} + 2e^- \rightarrow Sn \text{ (solid)} \qquad (3)$$

Some nano- or microcrystals grow on the surfaces of both source and drain electrodes. Once the crystals are large enough, they meet each other in the gap between the source and drain, and form a tin point-contact (6), which is the switching unit in the atomic-scale tin transistor of the present invention. The zoom-in of the tin point-contact (6) is shown in Fig. 1 with an on-state model. As the $U_G < U_{DS}$, the functions of the gate and the combination of source and drain electrodes are reversed. The oxidation reaction takes place on the combination and the reduction on the gate. The tin point-contact is dissolved because of oxidation. When the $U_{DS}$ is fixed, the tin point-contact can be built and dissolved reversibly by letting $U_G > U_{DS}$ or $U_G < U_{DS}$.
The energy consumption in the atomic-scale tin transistor comes from electrochemically building and dissolving the tin point-contact between the source and drain. These building and dissolving procedures of the point-contact involve the material transfer of tin atoms amid the gate and the combination of source and drain. The minimal switching energy ($E_{SW}$) is estimated by the product of the number ($N_{contact}$) of tin atoms building the point-contact, two electrons needed by reducing $Sn^{2+}$ ions, the potential difference between the gate and drain ($U_1$ (on) or $U_2$ (off) in volt), and one building and one dissolving procedure in a cycle. Therefore, the energy consumption of the atomic-scale tin transistor in one period is calculated as the sum of the dynamic and leakage parts according to Equation (4):

$$E_{total} \approx E_{dynamic} + E_{leakage} = \int_0^T I_G U_G dt + \int_0^T I_T U_{DS} d$$

$$\approx N_{contact} \cdot 2 \cdot e \cdot U_1 + N_{contact} \cdot 2 \cdot e \cdot U_2 + \int_0^T I_t U_{DS} dt \qquad (4),$$

where T is period T=1/f, f operation frequency, $U_{DS}$ the dc voltage applied across the drain and source electrodes, $I_G$ is the electrochemical current between gate and drain-source, $I_t$ is the tunneling current between the drain and source. The gap between the drain and source electrodes at the off-state in the atomic-scale tin transistor is calculated with the formula applied in electrochemical scanning tunneling microscopy (EC-STM) according to Equation (5) (cf. D. Woo et al., Surface Science 601, 1554-1559 (2007):

6

$$I_t(d) = AeU_{DS}\, exp\left(-4\pi \cdot \frac{\sqrt{2m\varphi}}{h} \cdot d\right) = AeU_{DS}\, exp\left(-1.025\sqrt{\varphi}d\right) \quad (5)$$

where A represents a constant, e represents electron charge, $\varphi$ represents the tunnel barrier in the electrolyte in volt, $U_{DS}$ represents the voltage across the drain and source, and d represents the gap width in Å. By considering the electrolyte concentration applied in the experiment, the tunnel barrier $\varphi$ is set at 1.6 V for further estimation. A tunneling regime with $R_T < 10^7\ \Omega$ was assigned approximately to a substrate-tip separation range < 1 nm in an EC-STM. With Equation (5), it is estimated that when the gap width increases 5.33 Å, the tunneling current should decrease by 1000 times. The tunneling current at off-state in the atomic-scale tin transistor was measured to be -1.7 nA when $U_{DS}$ was set to -3.23 mV, and the quantum conductance at on-state measured to be 16 Go. The gap is calculated to be 0.85 nm. The number of atoms ($N_{contact}$) in the point-contact in dimensions (length, 0.85 nm; diameter, 0.75 nm) with the conductance of 16 $G_0$ is calculated theoretically to be 80 at least.

In the atomic-scale tin transistor according to the present invention, the information carriers are tin atoms. Tin atoms as information carriers are considerably different from electrons or spin due to their natural weight and size. They are physically heavier and more massive. The mass ratio of a tin atom to an electron is $2.18 \times 10^5$. The through-barrier-tunneling probability of the information carriers can be estimated using the Wentzel-Kramers-Brillouin (WKB) approximation according to Equation (6):

$$p_{WKB} \approx exp\left(-\frac{4\pi\sqrt{2m}}{h} \cdot L \cdot \sqrt{E_b}\right) \quad (6),$$

where m denotes the carrier mass, L the barrier width, and $E_b$ the barrier height. Considering both the "classic" over-barrier transition and "quantum" through-barrier tunneling, using atoms as information carriers has apparent advantages for L < 2.5 nm. It has been confirmed both experimentally and theoretically that the conductive channel of the atomic-scale tin transistor according to the present invention can have geometrical dimensions of a few Å in diameter and $\leq$ 1 nm in length.

Different from the CMOS devices, the bit value is presented by the conductance of the point-contact in the atomic-scale tin transistor. However, in this case, information is easily transferred back to the electrical domain, where nearly all information processing takes place today. Therefore, the atomic-scale tin transistor fulfills the requirements, pointed out by K. Galatsi et al., IEEE transactions on Nanotechnology 8, 66-75 (2008) on an electronic device as an alternative to a CMOS device. The conductance of the tin point-contact as a physical state variable can reside in two distinguishable on/off states, can be controlled between the on/off states (write) by the gate potential, read by an electrical current through the tin point-contact, transmitted from one physical location to another via the electrical current, and initialized in a defined state (erase) just by setting the gate potential. It has been demonstrated that the conductance of the tin point-contact as a state variable can compete with the thermal noise bath at room temperature. Furthermore, the inner resistance of metallic atomic-scale transistors is $\leq$ 12.9 k$\Omega$, much less than that of molecular electronic devices (in decades M$\Omega$).

*Estimation of energy consumption in the interconnects and switching process*

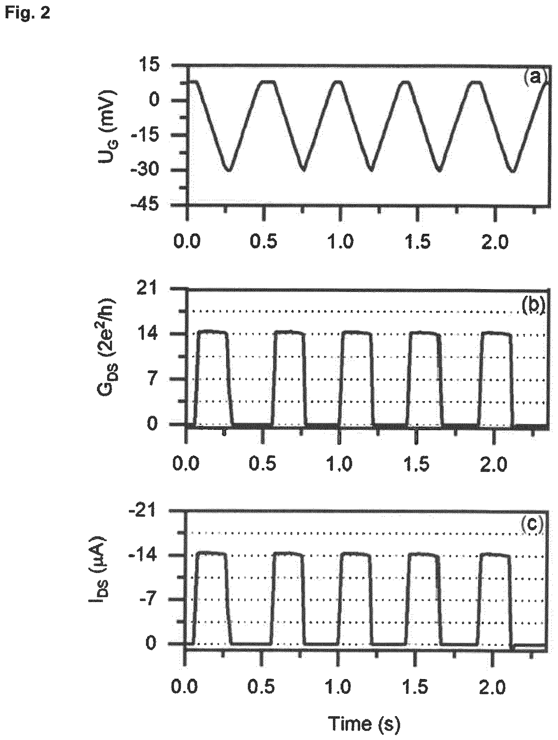

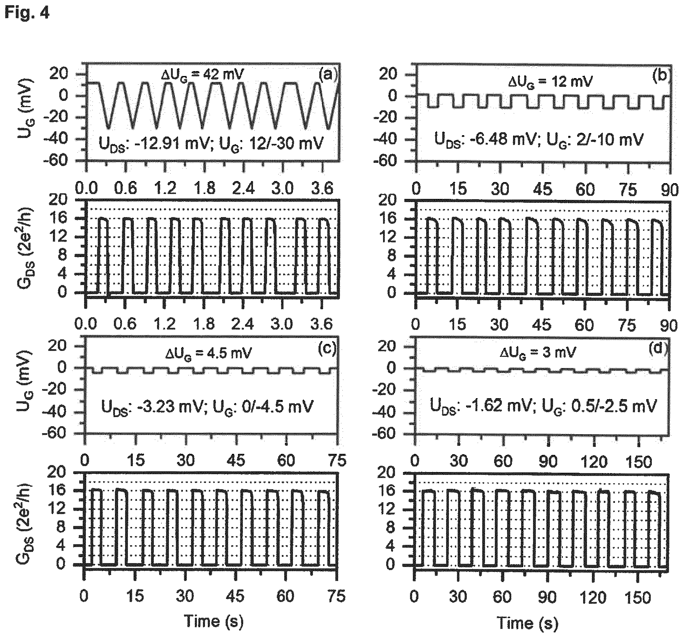

The projected supply voltage ($V_{DD}$) and gate length ($L_G$) at the technology node of "0.7 eq" in 2034 is 0.6 V and 12 nm, respectively. In charge-based CMOS logic circuits, the primary energy consumption source is electrical charging large capacitances in the interconnect wires. Indeed, transistor dynamic energy consumption constitutes ~12% at the 10 nm technology node, and 88% of energy is dissipated in the interconnects. The atomic-scale tin transistors of the present invention as an alternative could offer benefits beyond charge-based CMOS. Because the dynamic energy consumption is proportional to $V_{DD}^2$, the energy consumption in the interconnect wires might be reduced by at least 400 times {[600 mV/abs(-30 mV)]² = 400} or at maximum, 57600 times {[600 mV/abs(-2.5 mV)]² = 57600} if the CMOS devices could be replaced with atomic-scale tin transistors. The potential values at -30 mV and -2.5 mV are the maximal applied voltages in absolute as illustrated in Fig. 2, Fig. 4a, and Fig. 4d.

In the atomic-scale tin transistor of the present invention with quantum conductance at 16 Go, the minimal switching-on energy estimated with the first term in Equation (4) is 0.34 eV (13.1 $k_B$T at 300 K) when the reduction potential is 2.12 mV (0.5 mV-(-1.62)). The minimal energy is about 18.9 times larger than the ultimate limit on the minimum energy per switching at $k_B$Tln2 (Landauer's limit, approximately $3\times10^{-21}$ J at room temperature). The maximal energy is estimated to be 3.99 eV (~154.2 $k_B$T (at 300 K)) when the reduction potential of 24.91 mV (12 mV-(-12.91)) is taken from the switching sequence shown in Fig. 4a. However, the projected switching energy of a transistor at the technology node of "0.7 eq" is 193 $k_B$T (T at 300 K). The switching energy is about ~1.25 times (193 $k_B$T/154.2 $k_B$T, at maximum) or 14.7 times (193 $k_B$T/13.1 $k_B$T, at minimum) larger than the switching energy of the atomic-scale tin transistor with the tin point-contact with quantum conductance of 16 Go.

*Estimating the equivalency of driving current in CMOS devices and atomic-scale tin transistors*

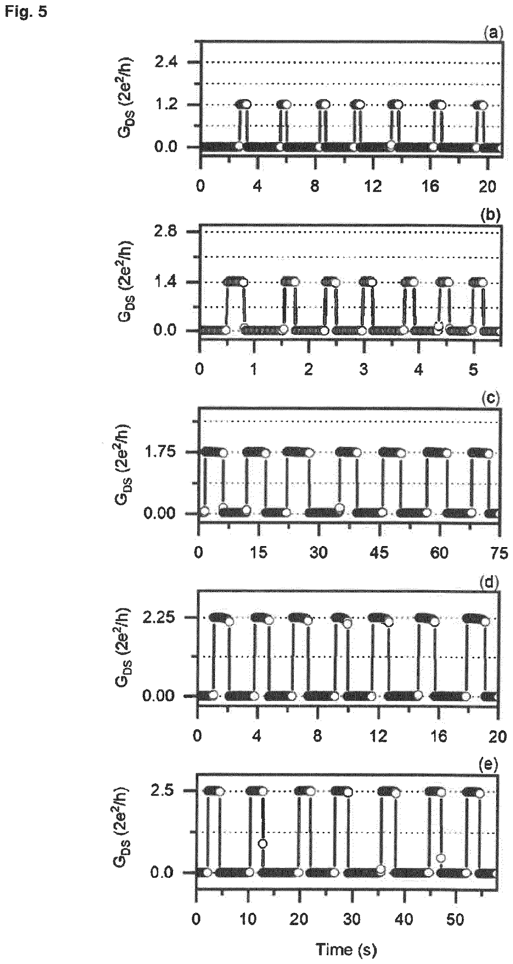

Fifteen switching sequences with different non-integer and integer quantum conductance are presented in Fig. 5, 6, and 7. The quantum conductance varies from 1.2 $G_0$ to 12 $G_0$. Since $U_{DS}$ was set at -12.91 mV, the corresponding on-state current ($I_{DS}$) through the devices changes from -1.2 $\mu$A to -12 $\mu$A. The $I_{DS}$ presented in Fig. 2, 3, 4a, and 8 were -14 $\mu$A, -7 $\mu$A, -16 $\mu$A, and ~ -80 $\mu$A, respectively. In an RC circuit, the time constant is $t = RC = \frac{V}{I} \cdot C$. Therefore, the delay time ($t_d$) of a single CMOS inverter is calculated as:

$$t_d = \frac{C_s V_{DD}}{I_{dsat}} \qquad\qquad (7)$$

where $C_s$ represents the total switching capacitance of a single inverter, $I_{dsat}$ represents the driving current, $V_{DD}$ represents the supply voltage. In the CMOS devices fabricated by Intel Company for its 10 nm technology node, $I_{dsat}$ is 176 $\mu$A (NMOS) and 139 $\mu$A (PMOS), and $V_{DD}$ 0.7 V, $I_{off}$ 1 nA. The $U_{DS}$ (-12.91 mV) in absolute is -54 times smaller than $V_{DD}$ (0.7 V) in the 10 nm technology node. The $I_{dsat}$ divided by 54 should be 3.24 $\mu$A (NMOS), 2.56 $\mu$A (PMOS), respectively. The $I_{DS}$ from the atomic-scale tin transistor at -3 $\mu$A is comparable with the driving current of CMOS devices in the 10 nm technology node. The corresponding quantum conductance of the atomic-scale tin transistor is 3 Go when the $U_{DS}$ is set at -12.91 mV. For logic operations, one "upstream" binary switch controls/communicates with several "downstream" binary switches. The number of downstream devices that are driven by a given upstream device is called "fan-out" (FO). A typical fan-out in logic circuits is three (FO3). If the atomic-scale tin transistor could be used as one "upstream" binary switch, the atomic-scale tin transistor should have quantum conductance at 9 Go and offer enough driving current at -9 $\mu$A with $U_{DS}$ (-12.91 mV).

With the formula mentioned above of the time delay ($t_d$), the equivalence of driving current can be built between the high-performance CMOS devices at the "5 nm" technology node [91.4 $\mu$A/device (on) and 1 nA/device (off), and $V_{DD}$ = 0.7 V] and the atomic-scale tin transistors ($I_{DS}$ = -1.68 $\mu$A and $U_{DS}$ = -12.91 mV).

*Fabricating and training the tin point-contact*

Fig. 1 shows the schematic diagram of an atomic-scale tin transistor of the present invention. In the present embodiment, atomic-scale tin transistors are operated electrochemically in an electrochemical cell protected by an inert gas (Ar or $N_2$) environment. The source and drain electrodes are made of one noble metal such as gold, silver, copper, and platinum, for instance. Commonly known lithography methods can be employed. The gap size is between a few micrometers such as 2 $\mu$m to 10 $\mu$m (photolithography), and decades of nanometers such as 60 to 160 nm (e-beam lithography). The distance between the drain and gate may be several decades of nanometers. The source and drain electrodes are insulated with a polymer except a small window crossing both electrodes for the electrochemical deposition of tin. The gate electrode consists of a piece of tin wire (diameter of 0.5 mm, Puratronic®, 99.9985%) or a noble metal film covered with a layer of tin. For conductance measurements, a dc $U_{DS}$ is applied to the drain electrode. The source electrode is virtually grounded via a trans-impedance circuit. The potential of the gate is changed with respect to the ground. Therefore, the potential differences between the gate, drain, and source are determined through $U_{DS}$ and the gate potential. The source, drain, and gate are immersed in one kind of electrolytes containing tin salts and acids such as $SnSO_4$+$H_2SO_4$, $SnCl_2$+HCl, $Sn(NO_3)_2$+$HNO_3$, and $SnSO_4$ +$HBO_3$.

To fabricate an initial tin point-contact in the gap between the source and drain, a potential at 30 mV is applied to the gate, and $U_{DS}$ is set at -12.9 mV. While tin islands are deposited in the polymer-free window on the source and drain, the conductance between the source and drain is monitored. When two of the tin islands on the source and drain meet each other in the gap, an atomic-scale tin point-contact is built. After the first junction forms between the source and drain, the deposition procedure continues for some time to stabilize the junction.

After the initial stage, the contact is opened just by setting the gate potential in the range between -18 mV and -30 mV. Then, the freshly opened junction is closed again by setting the gate potential between 2 mV and 12 mV. The cyclic deposition/dissolution procedure trains the freshly built atomic-scale tin transistor with the feedback mechanism, which is similar to the one previously described for the atomic-scale Ag transistors in WO 2006/026961 A2. After the cyclic training procedure, the atomic-scale tin point-contact forms bistable configurations and can perform bistable quantum conductive switching between the source and drain. The sign and the magnitude of the dc voltage ($U_{DS}$) applied across these two electrodes directly influence the growth of the tin point-contact. Such a trained atomic-scale tin transistor can implement quantum conductance switching via both the feedback mechanism and a function generator. For comparison and consistency, the high conductance is indicated in the quantum conductance unit of $G_0$.

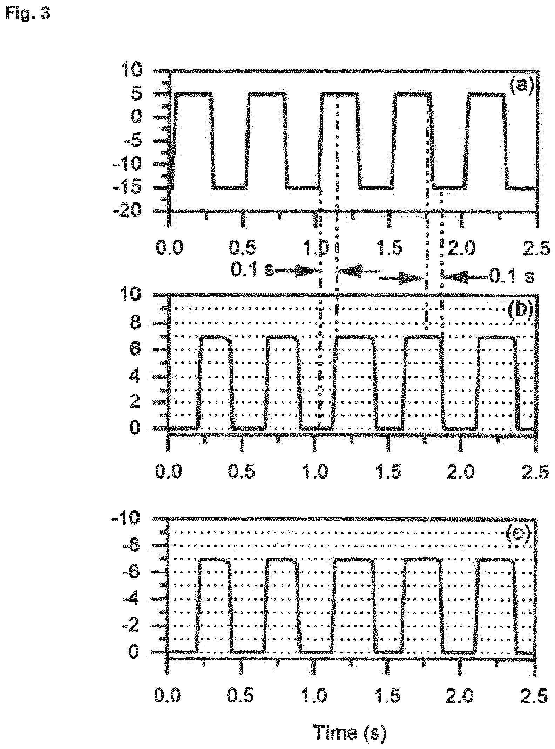

Following the gate potential via the feedback mechanism, Fig. 2 presents a high conductance (0 to 14 $G_0$) and current (0 to -14 $\mu$A) switching in one embodiment. Fig. 3 displays a virtual function-generator-controlled quantum conductance switching between 0 and 7 $G_0$ and current changing between 0 and -7 $\mu$A in another embodiment. The quantum conductance and the corresponsive current switching follow the variation of the gate potential in a delay in 0.1 s.

In the atomic-scale tin transistor, the potential differences between the gate, source, and drain are determined through $U_{DS}$ applied between the drain and source and the gate potential $U_G$. It is valuable to investigate possible on/off potential ranges on the gate to fabricate energy efficient atomic-scale tin transistors. In the embodiment described as follows, the fabrication procedure of atomic-scale tin transistors consists of three steps: building tin point-contact, training the point-contact, reducing the absolute value of $U_{DS}$, and decreasing the difference between $U_G$ and $U_{DS}$ from both upper and lower sides of $U_{DS}$. At the first stage, an atomic-scale tin point-contact was built electrochemically in the gap between the source and drain electrodes fabricated with the photo or e-beam lithography by setting $U_G$ at 30 mV and $U_{DS}$ at -12.9 mV. The point-contact was stabilized at 30 mV for a few minutes afterwards. At the second stage, the cyclic training process started just after the temporal stabilization and continued till a bistable configuration formed in the tin point-contact. At the third stage, the magnitude of $U_{DS}$ (-12.9 mV) was reduced by half, quarter, and one-eighth. After $U_{DS}$ was set at a fixed value, the on/off potentials approached the $U_{DS}$ from both upper and lower sides step by step. Fig. 4 illustrates four bistable switching sequences (0 to 16 Go) achieved by setting $U_{DS}$ at -12.91 mV (a), -6.48 mV (b), -3.23 mV (c), -1.62 mV (d), individually. The corresponding on/off potentials ($U_G$) were 12/-30 mV (a), 2/-10 mV (b), 0/-4.5 mV (c), and 0.5/-2.5 mV (d). In a general tendency, the switching period increases as the magnitudes of $U_{DS}$ and $U_G$ decrease. The absolute current values were reduced by half, quarter, and one eighth when the magnitude of $U_{DS}$ was decreased from -12.91 mV to -6.48 mV, -3.23 mV, and -1.62 mV, correspondingly. The values of current $I_{DS}$ were -16 $\mu$A (a), -8 $\mu$A (b), -4 $\mu$A (c), and -2 $\mu$A (d), respectively.

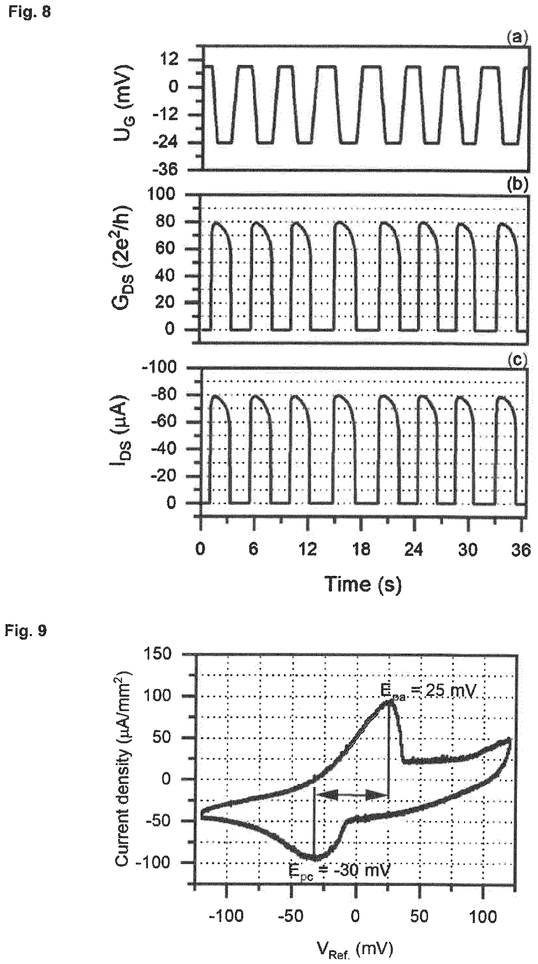

In the embodiment shown in Fig. 4d, the potential difference between the gate and drain is 2.12 mV(on)/-0.88 mV(off), and the potential interval between the gate and source is 0.5 mV(on)/-2.5 mV(off). These on/off potentials illustrated in Fig. 4d are consistent with the formal reduction potential (-2.5 mV) roughly determined with the cyclic voltammetry displayed in Fig. 9.

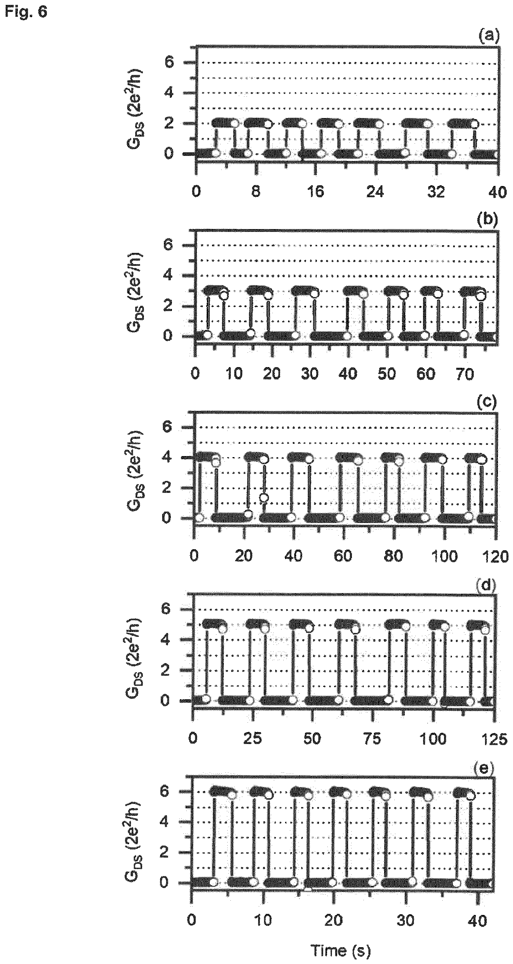

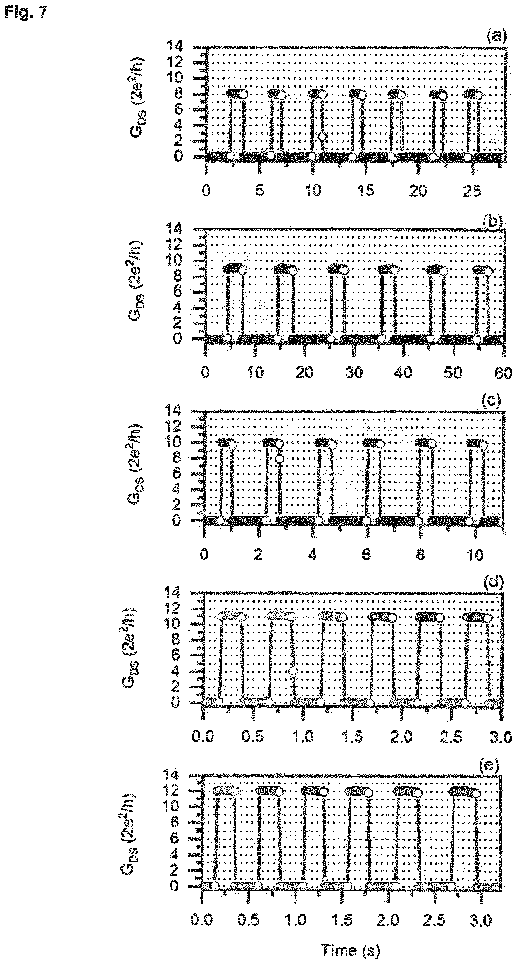

The diversity of possible bistable atomic configurations in atomic-scale tin transistors has been confirmed in a series of embodiments under the investigation of the operation behavior of atomic-scale tin transistors via the feedback mechanism. The series of embodiments are presented in Fig. 5 (non-integer quantum conductance at on-states) and Fig. 6 (integer quantum conductance at on-states). In the ten embodiments shown in Fig. 5 and Fig. 6, $U_{DS}$ was set at -12.91 mV. Ten switching sequences with seven cycles were selected as examples and presented each of the two figures. Because of comparison and clear presentation, the conductance is plotted on the same scale in each figure, but the scales are not the same for the two figures. The scales are -0.25 - 3 (Fig. 5), -0.5 - 7 (Fig. 6). Time axes vary to meet the time length of individual switching sequences. In Fig. 5, five graphs demonstrate that the atomic-scale tin transistors can implement operation between an "off-state" and "on-states" with non-integer quantum conductance at (a) 1.2 $G_0$, (b) 1.4 $G_0$, (c) 1.75 $G_0$, (d) 2.25 $G_0$, and (e) 2.5 $G_0$, respectively. The deposition/dissolution potentials for each switching sequence are 15/-35 mV (1.2 $G_0$), 15/-35 mV (1.4 $G_0$), 8/-24 mV (1.75 $G_0$), 10/-30 mV (2.25 $G_0$), and 10/-30 mV (2.5 $G_0$), separately. In Fig. 6, five digital wave plots illustrate the source-drain conductance switching between the non-conducting "off-state" and the conducting "on-state" with integer quantum conductance at (a) 2 $G_0$, (b) 3 $G_0$, (c) 4 $G_0$, (d) 5 $G_0$, and (e) 6 $G_0$, individually. The on/off potentials for each switching sequence are 8/-24 mV (2 $G_0$), 8/-24 mV (3 $G_0$), 8/-24 mV (4 $G_0$), 8/-24 mV (5 $G_0$), and 8/-24 mV (6 $G_0$), correspondingly. In Fig. 7, five graphs in rectangular waveform observed in five embodiments demonstrate the conductance switching sequences with on-states at (a) 8 $G_0$, (b) 9 $G_0$, (c) 10 $G_0$, (d) 11 $G_0$, and (e) 12 $G_0$, respectively. Since the plots utilize both line and empty circles (measured points), almost only direct transitions of closing edges were observed between these two states, and a few intermediate levels were found in the opening edges. This behavior is the same as that observed for the Pb atomic-scale transistors described previously. Thus, the results indicate that the switching transition of a tin point-contact is also due to a reproducible, bistable atomic-scale reconfiguration. The values of on/off switching potentials in each graph are 10/-30 mV (8 $G_0$), 10/-30 mV (9 $G_0$), 10/-30 mV (10 $G_0$), 8/-30 mV (11 $G_0$), and 8/-30 mV (12 $G_0$), correspondingly.

Following the gate potential via the feedback mechanism, Fig. 8 presents a high conductance (0 to 80 $G_0$) and current (0 to -80 $\mu$A) switching in one embodiment with $U_{DS}$ set at -12.9 mV. The absolute value of the current in this embodiment is directly comparable with the driving current in the high-performance CMOS devices at the "5 nm" technology node [91.4 $\mu$A/device (on) and 1 nA/device (off), and $V_{DD}$ = 0.7 V]. The values of on/off switching potentials in Fig. 8a are 9/-24 mV.

*Using cyclic voltammetry to determine the formal reduction potential*

Cyclic voltammetry was performed on one piece of gold wire in diameter of 0.25 mm as a working electrode and two pieces of tin wire in diameter of 0.5 mm as counter and quasi-reference electrodes. Within a sweeping range between -120 mV and 120 mV, the electrochemical potential was scanned reversibly at a rate of 4 mVs$^{-1}$ in the aqueous electrolytes of $SnSO_4$ (10 mM) + $H_2SO_4$ (40 mM). The cyclic voltammogram is plotted in Fig. 9 in the International Union of Pure and Applied Chemistry (IUPAC) convention. From the cyclic voltammogram, the cathodic peak potential ($E_{pc}$) is at -30 mV, and the anodic peak potential ($E_{pa}$) is at 25 mV. According to cyclic voltammetry, the formal reduction potential ($E^{0'}$) should be equal to ($E_{pa} + E_{pc}$)/2. Therefore, the formal reduction potential is determined with this cyclic voltammogram to be -2.5 mV. The electrochemical potential from the cyclic voltammogram can be translated into the potential applied to the gate electrode in the atomic-scale tin transistor, just multiplying the value by -1. The smallest reduction potential of tin is at ~2.5 mV, which has been confirmed in Fig. 4d.

*Demonstration of atoms instead of electrons as information carriers*

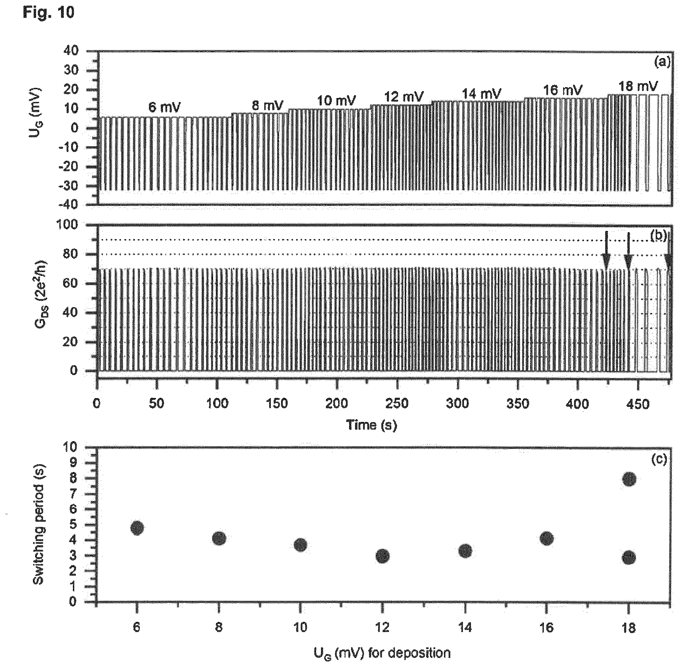

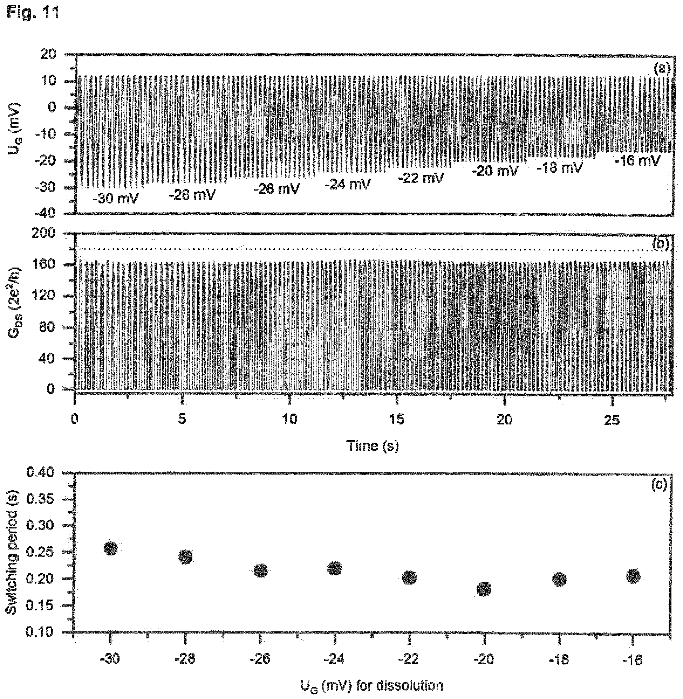

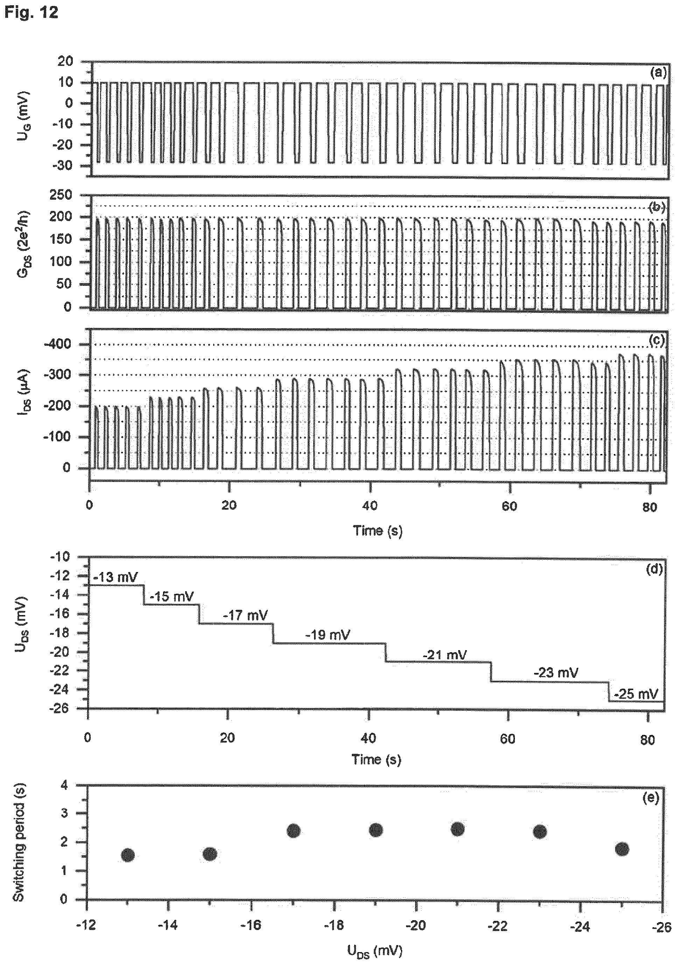

To confirm the influence of the gate potential ($U_G$) and drain-source dc voltage ($U_{DS}$) on the operation behaviors of atomic-scale tin transistors, the switching-on gate potential, the switching-off gate potential, and the drain-source dc voltage were changed in the step of 2 mV in three experiments, respectively. The experimental results are presented in Fig. 10 (via variation of the switching-on gate potential, 0-70 $G_0$ switching), Fig. 11 (via variation of the switching-off gate potential, 0-166 $G_0$ switching), and Fig. 12 (via variation of $U_{DS}$, 0-197 $G_0$ switching).

Graph (a) of Fig. 10 shows the switching-on gate potential increasing from 6 mV to 18 mV at the step of 2 mV. Graph (b) illustrates the conductance switching between 0 and 70 $G_0$. Three arrows mark the change of switching period while the switching-on potential was kept constant. Graph (c) presents the switching periods as solid round points vs. the switching-on gate potential ($U_G$). While the gate potential varied from 6 mV to 18 mV at the step of 2 mV, the conductance at on-state kept constant at 70 $G_0$. The on-state electric current was -70 $\mu$A as the $U_{DS}$ was set at -12.9 mV. The switching period decreased gradually when the switching-on potential increased from 6 mV to 12 mV and increased minorly when the potential varied from 12 mV to 16 mV. When the gate potential was set at 18 mV, the switching period jumped from low to higher level as marked with three arrows in Graph (b). Thus, although the conductance kept the same, the configuration of the tin point-contact changed during switching.

Graph (a) of Fig. 11 shows the switching-off gate potential increasing from -30 mV to -16 mV at the step of 2 mV. In the middle, Graph (b) illustrates the conductance switching between 0 and 166 $G_0$. At the bottom, Graph (c) presents the switching periods as solid round points vs. the gate potential. The on-state electric current was -166 $\mu$A as the $U_{DS}$ was set at -12.9 mV. The switching period decreased gradually when the switching-off gate potential increased from -30 mV to -20 mV at the step of 2 mV, and then raised minorly when the gate potential changed forward from -20 mV to -16 mV.

Graph (a) of Fig. 12 shows the gate potential switching between -28 mV (switching-off) and 10 mV (switching-on). Graph (b) illustrates the conductance switching between 0 and 197 $G_0$. Graph (c) presents the switching current through the drain and source electrodes. The switching-on current in magnitude increases as the absolute value of $U_{DS}$ increases. Graph (d) displays the stepwise change of $U_{DS}$ from -13 mV to -25 mV at the step of -2 mV. Finally, graph (e) demonstrates the switching period as solid round points vs. the drain-source dc voltage. Thus, the drain-source dc voltage influences the switching period.

Because the atomic-scale tin transistors perform bistable conductance switching, the conductance at on-states in these three figures keeps constant during variation of the gate potentials and the drain-source dc voltage. However, the variation of the gate potential and the drain-source dc voltage influences the switching period. The electric current at on-states does not depend on the gate potential during bistable conductance switching. Since the atomic-scale tin transistor has metallic point-contact at on-state, its I-V characteristic is Ohmic. The electric current at on-state is linearly proportional to the drain-source dc voltage as the graph of Fig.12c indicates. The current changes ($I_{DS}$) from -197 $\mu$A to -376 $\mu$A when $U_{DS}$ varies from -13 mV to -25 mV. The constant conductance at on-states in these three experiments demonstrates that the bistable configurations are robust. Therefore, atoms instead of electrons are information carriers in the atomic-scale tin transistors of the present invention.

The diversity of the bistable atomic configurations with different quantum conductance (from 1.2 $G_0$ to 197 $G_0$) in the atomic-scale tin point-contacts has been confirmed. The on-state current ($I_{DS}$) through the devices changes from -1.2 $\mu$A to -375 $\mu$A. The on/off current ratio can reach $2.2 \times 10^4$. With the formula of the time delay ($t_d$) in a single CMOS inverter, the equivalence of driving current can be built between the CMOS devices at the "5 nm" technology node and the atomic-scale tin transistors of the present invention. The $I_{DS}$ from the atomic-scale tin transistor at -1.68 $\mu$A ($U_{DS}$ = -12.91 mV) is comparable with the driving current [91.4 $\mu$A/device (on) and VDD = 0.7 V] of CMOS devices at the "5 nm" technology node.

**Claims**

1. An atomic-scale tin transistor device comprising:

    a source electrode (1);
    a drain electrode (2); and
    a gate electrode (3),
    wherein the source (1), drain (2), and gate (3) electrodes are spaced apart from one another and immersed in an electrolyte (4) containing tin ions in an electrochemical cell (5),
    wherein the source electrode (1) and drain electrode (2) are connected to each other in the on-state by a bistable atomic-scale tin point-contact (6) which can be reversibly opened and closed by dissolution/deposition potentials applied to the gate electrode (3), respectively, and
    wherein the atomic-scale tin point-contact (6) consists in the on-state at its narrowest point of at least one tin atom up to a few hundreds of tin atoms formed by electrochemical deposition of tin.

2. The tin transistor device according to claim 1, wherein the source (1) and drain (2) electrodes contain at least one metal selected from the group consisting of copper (Cu), ruthenium (Ru), rhodium (Rh), palladium (Pd), osmium (Os), iridium (Ir), platinum (Pt), gold (Au), and silver (Ag).

3. The tin transistor device according to claim 1 or 2, wherein the gate electrode (3) consists of a tin wire or a metal film covered with a layer of tin.

4. The tin transistor device according to any one of claims 1 to 3, wherein the electrolyte (4) is an aqueous electrolyte comprising tin salts and acids such as $SnSO_4 + H_2SO_4$, $SnCl_2 + HCl$, $Sn(NO_3)_2 + HNO_3$, and $SnSO_4 + HBO_3$.

5. The tin transistor device according to any one of claims 1 to 4, wherein the conductive channel length is 3 nm or less, preferably 1 nm or less.

6. The tin transistor device according to any one of claims 1 to 5, wherein the only movable parts of which are the tin atoms, which connect the source (1) and drain (2) electrodes.

7. The tin transistor device according to any one of claims 1 to 6, wherein the gate potential is less than 35 mV in magnitude.

8. The tin transistor device according to any one of claims 1 to 7, wherein the tunneling current at the off-state is less than 10 nA.

9. A method of producing an atomic-scale tin transistor device according to any one of claims 1 to 8, comprising:

    repeatedly applying potential cycles between the gate electrode (3) and the source (1) or drain electrode (2), respectively, for repeatedly depositing and dissolving tin atoms between the source electrode (1) and drain electrode (2) until the bistable atomic-scale tin point-contact (6) has been formed,
    wherein the potential during the potential cycles is increased and subsequently lowered as long as due to the change of the potential at the gate electrode (3), the conductance value between the source electrode (1) and the drain electrode (2) can reproducibly be switched between two conductance values as a function of the potential of the gate electrode (3).

10. The method according to claim 9, wherein the bistable atomic-scale tin point-contact (6) in the on-state at its narrowest point consists of only one tin atom or of a few tin atoms, and wherein by means of the tin transistor device an electrical circuit can be opened or closed through the change of the position of a single tin atom or a few tin atoms in the bistable atomic-scale tin point-contact (6).

11. The method according to claim 9 or 10, wherein the cycling process is carried out between two or more specified gate electrode (3) potentials, and wherein the potential is varied in a rectangular, triangle, trapezoid, or sinusoidal waveform.

12. Use of the atomic-scale tin transistor device according to any one of claims 1 to 8 as an atomic transistor or atomic relay.

**13.** Use according to claim 12 for logic switches and/or carrying out logic operations.

**14.** Use according to claim 12 or 13, wherein the transistor or relay is used in the range of ultra-high frequencies from the megahertz range over the gigahertz range to the terahertz range.

**15.** Use according to any one of claims 12 to 14 as building blocks of atom-based electronics.

Fig. 1

Tin point-contact

Gate potential

Electrolyte
in oxygen-free environment

Gate 3

Source 1     2   Drain

Substrate

U_Bias

Switching current

Fig. 2

Fig. 3

**Fig. 4**

**Fig. 5**

Fig. 6

**Fig. 7**

Fig. 8

Fig. 9

**Fig. 10**

## Fig. 11

**Fig. 12**

Europäisches
Patentamt

European
Patent Office

Office européen
des brevets

# EUROPEAN SEARCH REPORT

**Application Number**

EP 22 15 0675

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | XIE FANGQING ET AL: "Quasi-Solid-State Single-Atom Transistors", ADVANCED MATERIALS, vol. 30, no. 31, 1 August 2018 (2018-08-01), page 1801225, XP055948678, DE ISSN: 0935-9648, DOI: 10.1002/adma.201801225 Retrieved from the Internet: URL:https://api.wiley.com/onlinelibrary/td m/v1/articles/10.1002%2Fadma.201801225> * page 1 - pages 3, 6; figures 1, 2a * | 1-3,5-9, 11-15 | INV. H01L29/423 H01L29/786 H01L49/00 H01G9/00 H01G9/035 H01G9/042 |
| Y | US 2014/080274 A1 (PARK YOUNG JUNE [KR] ET AL) 20 March 2014 (2014-03-20) * paragraph [0058]; figure 4d * | 1-3,5-9, 11-15 | |
| X,P | XIE FANGQING ET AL: "Ultralow-Power Atomic-Scale Tin Transistor with Gate Potential in Millivolt", ADVANCED ELECTRONIC MATERIALS, 1 July 2022 (2022-07-01), page 2200225, XP055948683, ISSN: 2199-160X, DOI: 10.1002/aelm.202200225 Retrieved from the Internet: URL:https://onlinelibrary.wiley.com/doi/fu ll-xml/10.1002/aelm.202200225> * abstract; figures 1, 6 * | 1-15 | TECHNICAL FIELDS SEARCHED (IPC)  H01L H01G |

The present search report has been drawn up for all claims

| Place of search | Date of completion of the search | Examiner |
|---|---|---|
| Munich | 22 August 2022 | Angermeier, Detlef |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 0675

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2022

| Patent document cited in search report | Publication date | Patent family member(s) | Publication date |
|---|---|---|---|
| US 2014080274 A1 | 20-03-2014 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006026961 A2

**Non-patent literature cited in the description**

- **D. EIGLER et al.** *Nature,* 1991, vol. 352, 600
- **F.Q. XIE et al.** *Physical Review B,* 2017, vol. 95, 195415
- **BEILSTEIN.** *Journal of Nanotechnology,* 2017, vol. 8, 530-538
- **O. LIU et al.** *Cell,* 2018, vol. 175, 57-70
- Irreversibility and heat generation in the computing process. *IBM Journal of research and development,* 1961, vol. 5, 183-191
- **D. WOO et al.** *Surface Science,* 2007, vol. 601, 1554-1559
- **GALATSI et al.** *IEEE transactions on Nanotechnology,* 2008, vol. 8, 66-75